**Europäisches Patentamt**

**European Patent Office**

**Office européen des brevets**

(19)

(11) **EP 1 528 662 A1**

(12) **EUROPÄISCHE PATENTANMELDUNG**

| | |
|---|---|
| (43) Veröffentlichungstag:<br>**04.05.2005 Patentblatt 2005/18** | (51) Int Cl.⁷: **H02M 3/07** |

(21) Anmeldenummer: **05001856.3**

(22) Anmeldetag: **29.03.1999**

| | |
|---|---|
| (84) Benannte Vertragsstaaten:<br>**DE FR IT** | (72) Erfinder: **Feldtkeller, Martin**<br>**81543 München (DE)** |
| (30) Priorität: **24.04.1998 DE 19818465** | (74) Vertreter: **Bickel, Michael et al**<br>**Westphal - Mussgnug & Partner** |
| (62) Dokumentnummer(n) der früheren Anmeldung(en)<br>nach Art. 76 EPÜ:<br>**99106439.5 / 0 952 661** | **Patentanwälte**<br>**Mozartstrasse 8**<br>**80336 München (DE)** |
| (71) Anmelder: **Infineon Technologies AG**<br>**81669 München (DE)** | Bemerkungen:<br>Diese Anmeldung ist am 28 - 01 - 2005 als<br>Teilanmeldung zu der unter INID-Kode 62<br>erwähnten Anmeldung eingereicht worden. |

(54) **Schaltungsanordnung für eine Ladungspumpe und Spannungsreglerschaltung mit einer derartigen Schaltungsanordnung**

(57)    Schaltungsanordnung für eine Ladungspumpe, die eine erste Reihenschaltung von n Integratoren (IN1, IN2) und eine zweite Reihenschaltung von n weiteren Integratoren (IN3, IN4) umfaßt, die über Rückkopplungszweige miteinander verschaltet sind. Die einzelnen Integratoren (IN1 - IN4) können in Form von steuerbaren Integratoren ausgestaltet sein, die bei Anwendung in einer Spannungsreglerschaltung abhängig von dem Ausgangssignal eines Regelverstärkers (RV) eingestellt werden. Insbesondere kann mit Hilfe der steuerbaren Integratoren (IN1 - IN4) die Frequenz der Ladungspumpe (LP) lastabhängig angepaßt werden.

FIG 1

EP 1 528 662 A1

**Beschreibung**

Die vorliegende Erfindung betrifft eine Schaltungsanordnung für eine Ladungspumpe sowie einen Spannungsregler, bei dem eine derartige Schaltungsanordnung in einer Ladungspumpe zum Einsatz kommt.

Zum Betrieb verschiedener elektronischer Schaltungen ist der Einsatz von Spannungsreglern erforderlich, die für eine möglichst störungsfreie und stabilisierte Betriebsspannung sorgen. So benötigen beispielsweise elektronische Geräte in Kraftfahrzeugen Spannungsregler, die aus der von Störungen überlagerten Betriebsspannung (zwischen 12 und 15 V) eine störungsfreie stabilisierte Ausgangsspannung (in der Größenordnung von ca. 5 V) erzeugen. Die in diesem Anwendungsgebiet eingesetzten Spannungsregler müssen eine sehr niedrige Stromaufnahme (<100μA) haben, da die meisten elektronischen Kräftfahrzeugsysteme auch dann an das Bordnetz des Kraftfahrzeugs angeschlossen bleiben, falls das Kraftfahrzeug abgestellt wird, wobei jedoch die Autobatterie nicht entladen werden darf. Des weiteren sollen die verwendeten Spannungsregler einen möglichst geringen Spannungsabfall zwischen der Eingangs- und Ausgangsspannung ermöglichen, damit auch bei Einbrüchen der Versorgungs- bzw. Bordnetzspannung auf beispielsweise 5,5 V eine noch ausreichend hohe Ausgangsspannung aufrechterhalten werden kann.

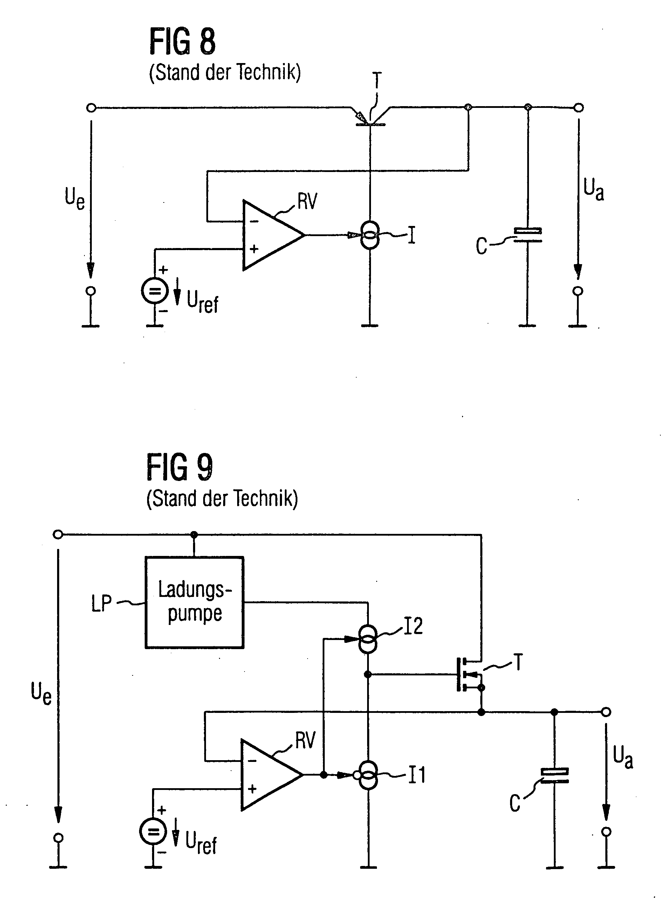

Fig. 8 zeigt ein vereinfachtes Blockschaltbild einer bekannten Spannungsreglerschaltung, wobei gemäß diesem Beispiel als Stellglied ein pnp-Stelltransistor T zum Einsatz kommt. Mit Hilfe dieses Stelltransistors T wird eine Eingangsspannung $U_e$ in eine möglichst störungsfreie und stabilisierte Ausgangsspannung $U_a$ umgewandelt. Ein Eingangsanschluß eines Regelungsverstärkers RV überwacht die Ausgangsspannung $U_a$ und erzeugt aufgrund eines Vergleichs mit einer an dem anderen Eingangsanschluß anliegenden Referenzspannung $U_{ref}$ ein Stellsignal für eine steuerbare Stromquelle I, die einen Steuerstrom für den Stelltransistor T erzeugt. Durch das Zusammenwirken des Stelltransistors T mit dem Regelungsverstärker RV und der steuerbaren Stromquelle I kann auf diese Weise die gewünschte stabilisierte Ausgangsspannung $U_a$ erzeugt werden. Die Verwendung des in Fig. 8 gezeigten pnp-Stelltransistors T ist aufgrund der dabei zum Einsatz kommenden kostengünstigen Bipolartechnologie vorteilhaft, welche leistungsfähige pnp-Transistoren ermöglicht.

Die Tendenz zukünftiger elektronischer Geräte geht jedoch in Richtung "Systems on Silicon", d. h. ein Chip soll möglichst viele verschiedene Funktionen beinhalten können, damit ein Gerät aus möglichst wenigen Chips aufgebaut werden kann. Daher wird angestrebt, Spannungsregler auf sogenannten "Smart Power Chips" zu integrieren, welche gemäß einer Mischtechnologie hergestellt werden, die einerseits für DMOS-Leistungstransistoren und CMOS-Logik optimiert sind und zudem bipolare Bauelemente aufweisen. Ein weiteres Ziel ist es, die Außenbeschaltung der Spannungsregler möglichst gering zu halten.

Der in Fig. 8 gezeigte Spannungsregler mit dem pnp-Bipolartransistor T erfordert jedoch stets einen eigenen Chip. Zudem ist aufgrund der niedrigen Transitfrequenz integrierter lateraler pnp-Transistoren der ebenfalls in Fig. 8 gezeigte relativ große Ausgangskondensator C erforderlich, der über einen möglichst weiten Temperaturbereich einen niedrigen Serienwiderstand aufweist. Der Kondensator C kann beispielsweise durch einen Tantal-Elektrolyt-Kondensator mit einer Kapazität zwischen 10 und 22 μF gebildet sein.

Für Smart-Power-Technologien wurden daher bisher Spannungsregler verwendet, die einen DMOS-Stelltransistor mit einer dazugehörigen Ladungspumpe zur Erzeugung der benötigten hohen Gatespannung aufweisen. Fig. 9 zeigt ein Blockschaltbild einer bekannten DMOS-Spannungsreglerschaltung, wobei diejenigen Bauteile, die denen in Fig. 8 gezeigten Bauteilen entsprechen, mit denselben Bezugszeichen versehen sind. Aus Fig. 9 ist ersichtlich, daß als Stelltransistor T ein n-Kanal-DMOS-Feldeffekttransistor verwendet wird, dessen Gateanschluß durch steuerbare Stromquellen I1 und I2 angesteuert wird. Die beiden Stromquellen I1 und I2 werden ihrerseits von dem Ausgangssignal des Regelungsverstärkers RV angesteuert, wobei die Stromquelle I1 durch das Ausgangssignal des Regelungsverstärkers RV invertiert zu der Stromquelle I2 eingestellt wird. Des weiteren ist in Fig. 9 eine Ladungspumpe LP dargestellt, die dafür sorgt, daß an dem Gateanschluß des Stelltransistors T eine erhöhte Gatespannung anliegt.

Der in Fig. 9 gezeigte Spannungsregler weist jedoch den Nachteil auf, daß er aufgrund der Ruhestromaufnahme der Ladungspumpe LP eine sehr hohe Stromaufnahme (z. B. einige mA) besitzt, so daß beispielsweise bei Kraftfahrzeuganwendungen der Spannungsregler auch bei abgestelltem Fahrzeug abgeschaltet werden muß. Die Verwendung von n-Kanal-DMOS-Transistoren ist jedoch in Spannungsreglern deshalb vorteilhaft, da sich allgemein pnp- oder p-Kanal-MOS-Transistoren nicht für Smart-Power-Chips eignen, da sie bei Anwendung der Smart-Power-Technologie nur mit geringen Stromdichten betrieben werden können.

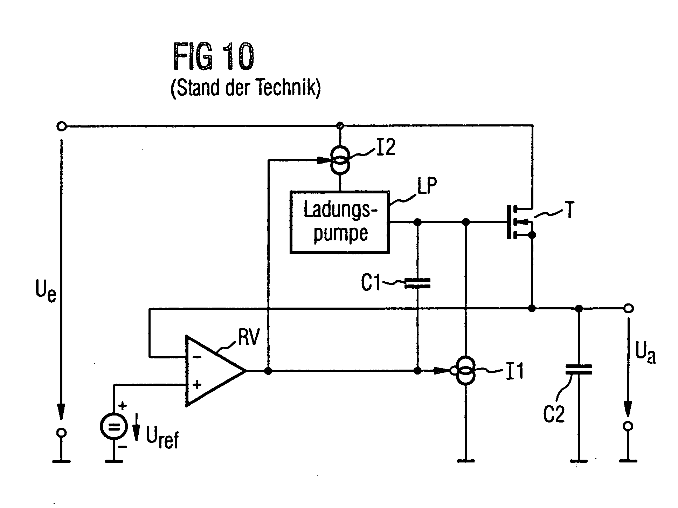

Fig. 10 zeigt ein Blockschaltbild einer weiteren bekannten Spannungsreglerschaltung, wie sie beispielsweise in der US-Patentschrift Nr. 5,654,628 offenbart ist. Dieser Spannungsregler umfaßt einen Eingangsanschluß zum Empfangen einer (ungeregelten) Eingangsspannung $U_e$ und einen Ausgangsanschluß zum Bereitstellen einer (geregelten) Ausgangsspannung $U_a$, wobei ein n-Kanal-DMOS-Feldeffekttransistor T als Stellglied zwischen den Eingangs- und Ausgangsanschluß geschaltet ist. Des weiteren wird wiederum ein Regelverstärker RV verwendet, der die geregelte Ausgangsspannung $U_a$ an einem seiner Eingänge empfängt und ein entsprechendes Ausgangssignal für steuerbare Stromquellen I1 bzw. I2 erzeugt. Ein Kondensator C1 ist zwischen den Ausgangsanschluß des Regelverstärkers RV und den Steueranschluß des Transistors T geschaltet. Die Stromquelle I2 entspricht der internen Stromquelle der Ladungspumpe LP, welche infolge einer entsprechenden Ansteuerung durch den Regelverstärker RV eine erhöhte Ausgangsspannung für den Transistor T erzeugt, um die Gatespannung des Transistors T zu stützen. Die Stromquelle I1 dient zum Entladen des Kondensators C1, wobei im Falle eines Abfalls der Ausgangsspannung $U_a$ ein erhöhtes Ausgangssignal des Regelverstärkers RV dafür sorgt, daß der Strom der Stromquelle I1 infolge der invertierten Ansteuerung durch den Regelverstärker RV verringert wird. Das Ausgangssignal des Regelverstärkers RV wird des weiteren über den Kondensator C1 dem Transistor T zugeführt, so daß das Signal $U_a$ am Ausgangsanschluß wegen des relativ konstanten Spannungsabfalls entlang des Gate-Source-Pfads des Transistors T erhöht wird. Mit Hilfe des Kondensators C1 können schnelle ausgangsseitige Laständerungen des Spannungsreglers ausgeglichen werden, und der Spannungsregler kann auch mit einer kleinen Ausgangskapazität C2 (z. B. mit einem 100 nF-Keramikkondensator) stabil arbeiten.

Wie bereits zuvor anhand Fig. 9 und 10 erläutert worden ist, werden häufig Ladungspumpen zur Ansteuerung von Leistungs-MOS-Transistoren eingesetzt. Damit die dabei verwendete Ladungspumpenschaltung mit möglichst kleinen integrierten Kondensatoren auskommt, muß sie jedoch mit einer möglichst hohen Frequenz betrieben werden, wodurch jedoch das Problem der elektromagnetischen Abstrahlung entsteht. Um diesem Problem entgegenzuwirken, wurde beispielsweise in der EP 0633662 A1 eine Ladungspumpe vorgeschlagen, welche eine Schaltungsanordnung umfaßt, die mehrere ineinander verschachtelte Signale erzeugt, wobei jeweils zwei dieser Signale genau komplementär zueinander verlaufende und abgeflachte Flanken aufweisen, die zu einer geringeren elektromagnetischen Abstrahlung der Ladungspumpe führen. Die in der EP 0 633 662 A1 beschriebene Schaltungsanordnung entspricht im wesentlichen einem Ringoszillator mit zwei Reihenschaltungen aus mehreren Treiberstufen, wobei der Ausgang der letzten Treiberstufe der einen Reihenschaltung mit dem Eingang der ersten Treiberstufe der anderen Reihenschaltung verbunden ist. Die Ausgänge der Treiberstufen der einzelnen Reihenschaltungen sind über Haltestufen miteinander verbunden, die beispielsweise durch jeweils zwei entgegengesetzt zueinander verschaltete Inverter gebildet sind. An den Ausgängen der einzelnen Treiberstufen können invertierte Ausgangssignale abgegriffen werden. Wie bereits erläutert worden ist, ist mit Hilfe dieser Schaltungsanordnung eine Unterdrückung von Störaussendungen möglich, was bei Spannungsreglern von erheblicher Bedeutung ist. Die in der EP 0 633 662 A1 beschriebene Ladungspumpe erzeugt jedoch rechteckförmige Ausgangssignale, wodurch grundsätzlich - wenn auch in geschwächter Form - weiterhin Störungen ausgesendet werden.

Der vorliegenden Erfindung liegt unter Berücksichtigung des zuvor erläuterten Stands der Technik somit die Aufgabe zugrunde, eine verbesserte Schaltungsanordnung für eine Ladungspumpe zu schaffen, die insbesondere eine verringerte Stromaufnahme ermöglicht und für den Einsatz in Spannungsreglern auf Smart-Power-ICs gemäß der DMOS-Technologie geeignet ist. Des weiteren soll die Schaltungsanordnung eine verbesserte elektromagnetische Verträglichkeit (EMV) aufweisen.

Darüber hinaus liegt der vorliegenden Erfindung die Aufgabe zugrunde, einen verbesserten Spannungsregler zu schaffen, der bei vorgegebener maximaler Ausgangsspannung eine verringerte Stromaufnahme aufweist.

Die vorstehenden Aufgaben werden gemäß der vorliegenden Erfindung hinsichtlich der Schaltungsanordnung durch eine Schaltungsanordnung für eine Ladungspumpe mit den Merkmalen des Anspruches 1 und hinsichtlich des Spannungsreglers durch eine Spannungsreglerschaltung mit den Merkmalen des Anspruches 19 gelöst. Die Unteransprüche beschreiben jeweils bevorzugte und vorteilhafte Ausführungsformen der vorliegenden Erfindung, die ihrerseits zu einem möglichst einfachen Aufbau der erfindungsgemäßen Schaltungsanordnung bzw. Spannungsreglerschaltung sowie einer möglichst geringen Stromaufnahme und bestmöglicher Stabilität beitragen.

Die Schaltungsanordnung weist gemäß der vorliegenden Erfindung zwei Reihenschaltungen aus mehreren Integratoren auf, die jeweils über entsprechende Rückkopplungszweige miteinander gekoppelt sind, so daß an den Ausgängen der einzelnen Integratoren entsprechende zueinander phasenversetzte sinusförmige Ausgangssignale erzeugt werden können, was im Gegensatz zu den aus der EP 0 633 662 A1 bekannten phasenverschobenen Rechteckimpulsen hinsichtlich der elektromagnetischen Verträglichkeit (EMV) vorteilhaft ist. Vorteilhafterweise umfaßt die Schaltungsanordnung vier Integratoren, die somit vier jeweils um 90° gegeneinander phasenversetzte näherungsweise sinusförmige Ausgangssignale erzeugen.

Vorteilhafterweise sind die Integratoren in Form von gesteuerten Invertern mit mehreren Eingängen realisiert, so daß bestimmte Eigenschaften dieser Integratoren durch Anlegen entsprechender Steuersignale verändert werden können. Dabei liegt diesem Erfindungsaspekt insbesondere die Erkenntnis zugrunde, daß die Stromaufnahme der Schaltungsanordnung bzw. des gesamten Spannungsreglers deutlich reduziert werden kann, wenn die (Schaltungs-)Frequenz der Ladungspumpe soweit vermindert wird, daß die Stromabgabe der Ladungspumpe auf einen geforderten Wert absinkt. Durch Ansteuerung der steuerbaren Integratoren der Schaltungsanordnung können somit beispielsweise vier jeweils um 90° gegeneinander phasenversetzte näherungsweise sinusförmige Ausgangssignale erzeugt werden, deren Frequenz mit Hilfe externer Steuersignale verändert werden kann.

Besonders vorteilhaft ist die Verwendung der erfindungsgemäßen Schaltungsanordnung in einem Spannungsregler der eingangs beschriebenen Art, wenn der dabei verwendete Regelverstärker als sogenannter Class-B-Verstärker mit geringem Ruhestrom ausgeführt ist und bei einer genügend hohen Eingangsspannung ein Steuersignal für die Ladungspumpe des Spannungsreglers erzeugt, welches der Ausgangsfrequenz Null entspricht. Dabei wird eine zusätzliche Stromquelle eingesetzt, die in diesem Fall die für den DMOS-Stelltransistor nötige Gateladung aufrechterhält.

Die im Zusammenhang mit dem erfindungsgemäßen Spannungsregler vorgeschlagene frequenzvariable Ladungspumpe läßt sich insbesondere für sogenannte High-Side-Schalter einsetzen, bei denen ein schnelles Einschalten und bei eingeschaltetem Schalter eine niedrige Störaussendung mit geringer Stromaufnahme gefordert ist.

Die vorliegende Erfindung wird nachfolgend anhand bevorzugter Ausführungsbeispiele unter Bezugnahme auf die Zeichnungen näher erläutert.

Fig. 1 zeigt ein Blockschaltbild eines bevorzugten Ausführungsbeispiels eines Spannungsreglers gemäß der vorliegenden Erfindung,

Fig. 2a -.2c zeigen Darstellungen zur Erläuterung der Tatsache, warum durch Verringerung der Frequenz der Ladungspumpe die Stromaufnahme reduziert werden kann,

Fig. 3 zeigt ein Schaltbild eines bevorzugten Ausführungsbeispiels einer Schaltungsanordnung für eine Ladungspumpe gemäß der vorliegenden Erfindung,

Fig. 4 zeigt ein detailliertes Schaltbild eines in Fig. 3 dargestellten Integrators,

Fig. 5 zeigt ein detailliertes Schaltbild eines in Fig. 3 gezeigten Treibers,

Fig. 6 zeigt ein detailliertes Schaltbild einer Schaltung zur Erzeugung von Steuersignalen für die in den Fig. 3-5 gezeigten Integratoren und Treiber,

Fig. 7 zeigt ein Schaltbild eines Spannungsreglers gemäß einem weiteren bevorzugten Ausführungsbeispiel der vorliegenden Erfindung, und

Fig. 8 - 10 zeigen Schaltbilder bekannter Spannungsregler.

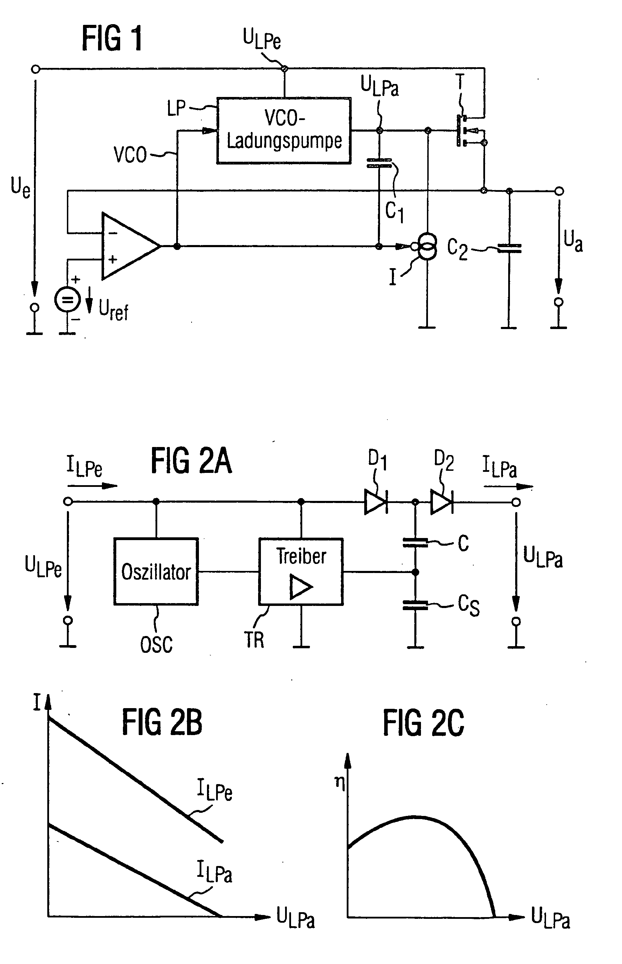

Das in Fig. 1 gezeigte bevorzugte Ausführungsbeispiel eines erfindungsgemäßen Spannungsreglers entspricht im wesentlichen dem in Fig. 10 gezeigten Spannungsregler. Der in Fig. 1 gezeigte Spannungsregler umfaßt einen Eingangsanschluß zum Empfangen einer ungeregelten Eingangsspannung $U_e$ sowie einen Ausgangsanschluß zum Bereitstellen einer (geregelten) Ausgangsspannung $U_a$. Ein Stelltransistor T ist mit seinem Hauptstrompfad bzw. seiner Laststrecke zwischen den Eingangs- und den Ausgangsanschluß geschaltet. Gemäß Fig. 1 ist der Transistor T insbesondere in Form eines n-Kanal-DMOS-Feldeffekttransistors ausgebildet. Ein Regelverstärker RV überwacht an seinem invertierten Eingang die am Ausgangsanschluß bereitgestellte Ausgangsspannung $U_a$ und vergleicht diese mit einer an seinem weiteren Eingang anliegenden Referenzspannung $U_{ref}$. Ein Kondensator T1 ist zwischen den Ausgang des Regelverstärkers RV und den Steuer- bzw. Gateanschluß des Stelltransistors T geschaltet. Eine Stromquelle I dient zum Entladen des Kondensators C1 und wird invertiert von dem Ausgangssignal des Regelverstärkers RV gesteuert. Des weiteren ist eine Ladungspumpe LP vorgesehen, welche eine erhöhte Spannung für den Steueranschluß des Stelltransistors T erzeugt. Am Ausgang des Spannungsreglers ist ein Ausgangskondensator C2 vorgesehen, über den die Ausgangsspannung $U_a$ ausgegeben wird.

Im Gegensatz zu dem in Fig. 10 gezeigten Spannungsregler wird jedoch gemäß dem in Fig. 1 gezeigten Ausführungsbeispiel die Frequenz der Ladungspumpe LP durch das Ausgangssignal des Regelverstärkers RV eingestellt, d. h. bei der Ladungspumpe LP handelt es sich um eine spannungsgesteuerte frequenzvariable Ladungspumpe (VCO-Ladungspumpe), wobei die Frequenz der Ladungspumpe LP zur Verringerung der Stromaufnahme an die jeweiligen Bedürfnisse angepaßt wird.

Dies soll nachfolgend näher anhand der in Fig. 2a - 2c dargestellten Diagramme erläutert werden.

Fig. 2a zeigt ein stark vereinfachtes Blockschaltbild einer verdoppelnden Ladungspumpe, die in Übereinstimmung mit Fig. 1 als Eingangsspannung eine Spannung $U_{LPe}$ empfängt und eine Ausgangsspannung $U_{LPa}$ ausgibt. Gemäß Fig. 2a kann die Ladungspumpe als Kombination eines Ringoszillators OSC mit einem nachfolgenden Treiber TR dargestellt werden, wobei die Ausgangssignale des Treibers TR über ein Dioden-Kondensator-Netzwerk mit Dioden D1 und D2 sowie einem Pumpkondensator C ausgegeben werden. Des weiteren ist in Fig. 2a ein Kondensator $C_s$ dargestellt, welcher der unvermeidlichen, durch die monolithische Integration bedingten parasitären Substratkapazität der in der Ladungspumpe verwendeten Pumpkondensatoren entspricht. Zwischen dem von der verdoppelnden Ladungspumpe aufgenommenen Strom $I_{LPe}$ und dem abgegebenen Strom $I_{LPa}$ bestehen folgende Zusammenhänge:

$$I_{LPe}=C_s \cdot f \cdot U_{LPe}+2 \cdot C \cdot f \cdot (2 \cdot U_{LPe}-U_{LPa}-2 \cdot U_D)$$

$$I_{LPa}=C \cdot f \cdot (2 \cdot U_{LPe}-U_{LPa}-2 \cdot U_D)$$

In Fig. 2b ist der Verlauf des aufgenommenen Stroms $I_{LPe}$ und des abgegebenen Stroms $I_{LPa}$ in Abhängigkeit von der Ausgangsspannung $U_{LPa}$ der verdoppelnden Ladungspumpe dargestellt. Aus den obigen Formeln ist ersichtlich, daß der für die periodische Auf- und Entladung der parasitären Kapazitäten nötwendige Ladestrom einen Hauptanteil der Leerstromaufnahme einer Ladungspumpe darstellt. Weitere Anteile der Ruhestromaufnahme der Ladungspumpe entstehen zudem durch Querströme der Treiberstufen TR und durch die Stromaufnahme des Oszillators OSC.

Ergänzend ist in Fig. 2c der Wirkungsgrad in Abhängigkeit von der Ausgangsspannung $U_{LPa}$ dargestellt. Dabei ist aus Fig. 2c ersichtlich, daß der Wirkungsgrad n bei Leerlauf der Ladungspumpe gleich Null ist und ein Maximum besitzt, welches bei einer Eingangsspannung $U_{LPe}$ =5V, einer Nutzkapazität C=5 pF und einer Substratkapazität $C_s$=1,2 pF bei einer Ausgangsspannung $U_{LPa}$ = 7V liegt. Wird von der Ladungspumpe nur eine geringe Leistungsabgabe gefordert, was beispielsweise bei eingeschwungenem Regelkreis und bei geringer Belastung des Spannungsreglers der Fall ist, sollte die Ladungspumpe aus diesem Grunde nicht leerlaufen, was zunächst naheliegend wäre, oder die Eingangsspannung $U_{LPe}$ der Ladungspumpe verringert werden, was gemäß der US 5,654,628 (vergl. Fig. 10) vorgeschlagen wird.

Vielmehr ist es vorteilhaft, statt dessen die Frequenz der Ladungspumpe soweit zu verringern, daß die Stromabgabe der Ladungspumpe auf den gewünschten bzw. geforderten Wert absinkt, um auf diese Weise eine sehr geringe Stromaufnahme zu erzielen. Daher ist gemäß Fig. 1 die Ladungspumpe LP derart ausgestaltet, daß ihre Frequenz abhängig von dem Ausgangssignal des Regelverstärkers RV variabel ist. Dabei kann die Ladungspumpe LP als mehrphasige Ladungspumpe ausgestaltet sein, die mehrere gegeneinander phasenversetzte sinusförmige Ausgangssignale erzeugt, wobei die Frequenz dieser Ausgangssignale mit Hilfe des Steuersignals VCO des Regelverstärkers RV veränderbar ist. Die mit der Ladungspumpe LP höchste erzeugbare Frequenz sollte vorteilhafterweise genauso hoch sein wie die mit Hilfe eines auf Inverterlaufzeiten basierenden Oszillators erzeugbare Frequenz (vergl. die eingangs beschriebene EP 0 633 662 A1).

Aus IEEE Journal of Solid-State Circuits, VOL. 32, NO.6, June 1997, "Efficiency Improvement in Charge Pump Circuits" ist im Prinzip bereits die Verwendung von frequenzvariablen Ladungspumpen bekannt. Insbesondere ist in dieser Druckschrift das Problem beschrieben, daß Ladungspumpen Transistorschaltungen verwenden, welche mit einer bestimmten Schaltfrequenz betrieben werden, wobei gemäß dem bekannten Stand der Technik die Schaltfrequenz derart festgelegt wird, daß auch bei einer maximalen Ausgangslast der Ladungspumpe ein ausreichend hoher Ausgangssignalpegel erzielt werden kann, wobei dies jedoch zur Folge hat, daß bei einer geringen Belastung der Ladungspumpe unnötigerweise ein beträchtlicher Versorgungsstrom benötigt wird, so daß insbesondere bei Systemen, die größtenteils ohne Last betrieben werden, ein erheblicher Energieverbrauch die Folge ist. Demzufolge wurde in dieser Druckschrift vorgeschlagen, die Schaltfrequenz der Ladungspumpe abhängig von der Last zu variieren, so daß bei einer geringeren Last die Schaltfrequenz der Ladungspumpe reduziert wird, was eine verbesserte Leistungsfähigkeit, einen geringeren Stromverbrauch und geringere Durchbruchspannungsanfordernisse der Ladungspumpe zur Folge hat. In dieser Druckschrift wird jedoch nicht der Einsatz der Ladungspumpe in Spannungsreglerschaltungen beschrieben, so daß diese Druckschrift auch keinen Vorschlag macht, wie die Ansteuerung der Ladungspumpe in einer Spannungsreglerschaltung erfolgen könnte, um die Frequenz der Ladungspumpe zu variieren.

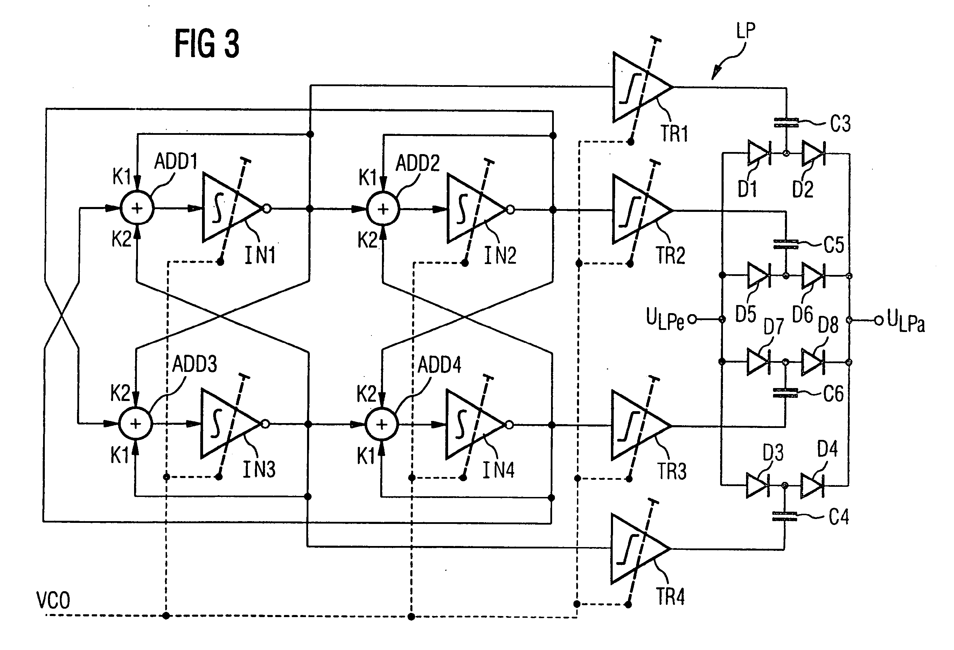

Dagegen zeigt Fig. 3 ein Schaltbild eines bevorzugten Ausführungsbeispiels der in Fig. 1 dargestellten frequenzvariablen Ladungspumpe LP, die zudem die zuvor gekannten Voraussetzungen erfüllt. Die in Fig. 3 gezeigte Schaltung umfaßt zwei Reihenschaltungen, die mehrere gemeinsam angesteuerte Integratoren bzw. Integrierer IN1 -IN4 aufweisen, wobei die einzelnen Integratoren IN1-IN4 über Rückkopplungszweige miteinander verschaltet sind. Insbesondere ist in Fig. 3 ein Beispiel einer verdoppelnden mehrphasigen Ladungspumpe dargestellt, wobei jede Reihenschaltung zwei gesteuerte Integratoren IN1, IN2 bzw. IN3, IN4 aufweist. Der Ausgang des letzten Integrators einer jeden Reihenschaltung ist an den Eingang des ersten Integrators der anderen Reihenschaltung geführt. Des weiteren ist der Ausgang eines jeden Integrators über einen ersten Rückkopplungszweig mit dem Verstärkungsfaktor K1 an seinen Eingang und über einen zweiten Rückkopplungszweig mit dem Verstärkungsfaktor K2 an den Eingang des entsprechenden Integrators der anderen Reihenschaltung geführt. Das Eingangssignal eines jeden Integrators IN1 - IN4 entspricht dem Ausgangssignal eines Addierers ADD1 - ADD4. Somit entspricht das Eingangssignal der Integratoren IN1 bzw. IN3 dem Summensignal aus dem Ausgangssignal des Integrators IN4 bzw. des Integrators IN2, dem mit dem Verstärkungsfaktor K1 multiplizierten Ausgangssignal des Integrators IN1 bzw. IN3 und dem mit dem Verstärkungsfaktor K2 multiplizierten Ausgangssignal des Integrators IN3 bzw. IN1. Das Eingangssignal der Integra-toren IN2 bzw. IN4 entspricht hingegen dem Summensignal aus dem Ausgangssignal des Integrators IN1 bzw. IN3, dem mit dem Verstärkungsfaktor K1 multiplizierten Ausgangssignal des Integrators IN2 bzw. IN4 und dem mit dem Verstärkungsfaktor K2 multiplizierten Ausgangssignal des Integrators IN4 bzw. IN2.

Die Verstärkungsfaktoren der Rückkopplungszweige sind derart eingestellt, daß gilt: K2>K1, K2-K1<1 (Schwingbedingung) und K1+K2>1 (Stabilitätsbedingung).

Gemäß Fig. 3 werden die einzelnen Integratoren IN1 - IN4 abhängig von dem Steuersignal VCO des in Fig. 1 gezeigten Regelverstärkers RV angesteuert. An den Ausgängen der einzelnen Integratoren IN1 - IN4 werden zueinander jeweils um 90° phasenversetzte näherungsweise sinusförmige Ausgangssignale abgegriffen, die über Treiberstufen TR1 - TR4 geführt werden, wobei auch diese Treiberstufen TR1 - TR4 vorzugsweise abhängig von dem Steuersignal VCO eingestellt werden, um beispielsweise die Flankensteilheit der Treiber TR1 - TR4 zu verändern. Die Ausgangssignale werden über ein DiodenKondensator-Netzwerk mit Kondensatoren C3 - C6 und Dioden D1 - D8 mit der an der Ladungspumpe anliegenden Eingangsspannung $U_{LPe}$ kombiniert, um schließlich die erhöhte Ausgangsspannung $U_{LPa}$ zu erhalten.

Obwohl gemäß Fig. 3 die Schaltungsanordnung mit steuerbaren Integratoren IN1 - IN4 und steuerbaren Treibern TR1 - TR4 ausgestaltet ist, kann die in Fig. 3 gezeigte Schaltungsanordnung selbstverständlich auch ohne Steuerbarkeit der Integratoren und/oder Treiber ausgestaltet sein, da auch in diesem Fall an den Ausgängen der Integratoren zueinander phasenversetzte sinusförmige Signale abgegriffen werden können, was hinsichtlich der elektromagnetischen Verträglichkeit (EMV) deutlich vorteilhaft im Vergleich zu den aus der EP o 633 662 A1 bekannten phasenverschobenen Rechteckimpulsen ist.

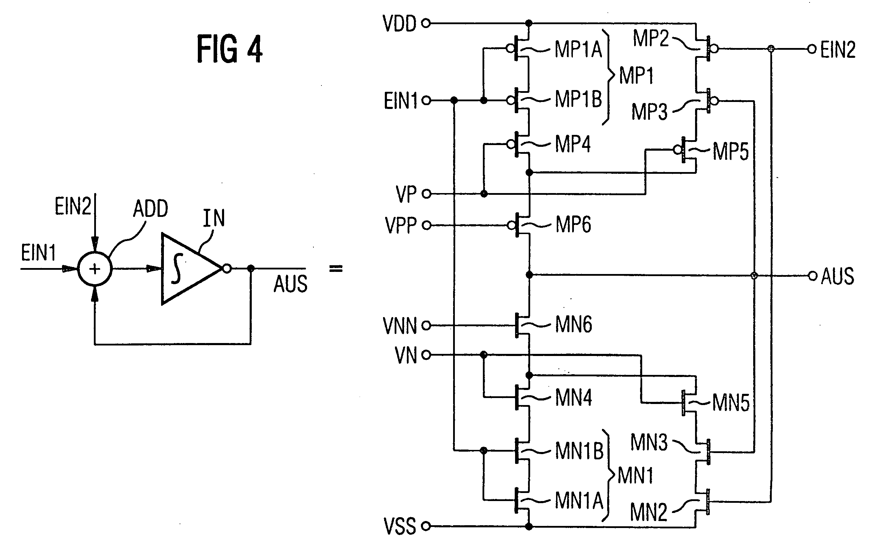

Die in Fig. 3 gezeigten gesteuerten Integratoren IN1 - IN4 können als gesteuerte Inverter mit mehreren Eingängen, insbesondere mehreren Steuereingängen, realisiert werden. Dabei bildet die steuerbare Übertragungskennlinie des Inverters zusammen mit der Verdrahtungskapazität jeweils einen steuerbaren Integrator. Fig. 4 zeigt eine mögliche Schaltung für einen steuerbaren Integrator.

Gemäß Fig. 4 umfaßt die Schaltung einen positiven Versorgungsspannungsanschluß VDD, einen negativen Versorgungsspannungsanschluß VSS, einen ersten Eingangsanschluß EIN1 für das erste Eingangssignal des entsprechenden Addierers, einen zweiten Eingangsanschluß EIN1 für das zweite Eingangssignal des entsprechenden Addierers sowie vier Steueranschlüsse VP, VPP, VNN und VN, an die entsprechende Steuersignale anzulegen sind. Der in Fig. 4 gezeigte Integrator bzw. Inverter ist durch eine Kombinationsschaltung von p-Kanal- und n-Kanal-Sperrschicht-Feldeffekttransistoren aufgebaut. Dabei bilden die Transistoren MN1 - MN3 und MP1 - MP3 von den Eingangssignalen abhängige gesteuerte Widerstände. Diese Widerstände können wahlweise parallel oder in Serie geschaltet werden, wobei durch Parallelschaltung die maximal mögliche Frequenz des Oszillators der Ladungspumpe erhöht und durch Serienschaltung die Stromaufnahme des Oszillators vermindert werden kann. Gemäß dem in Fig. 4 gezeigten Ausführungsbeispiel wurde eine Kombination aus Parallel- und Serienschaltung gewählt, die sich als günstiger Kompromiß erwiesen hat, wobei jeweils zwei Transistoren MN2, MN3 bzw. MP2, MP3 in Serie geschaltet sind, während dazu parallel ein weiterer Transistor MN1 bzw. MP1 angeordnet ist. Aus Gründen der Fertigbarkeit sind jedoch gemäß Fig. 4 auch die nicht in Serie geschalteten Transistoren MN1 und MP1 ebenfalls in Form einer Serienschaltung aus jeweils zwei Transistoren MN1A und MN1B bzw. MP1A und MP1B ausgeführt. Die notwendigen Verstärkungsfaktoren der einzelnen Eingänge können durch unterschiedliche Kanallängen und Kanalweiten der Transistoren eingestellt werden. Des weiteren umfaßt die in Fig. 4 gezeigte Schaltung Transistoren MN4, MN5 und MN5, MP5, welche als Stromquellentransistoren dienen und abhängig von den Steuersignalen VP und VN den Gesamt-Stromfluß über den Inverter und damit die Übertragungskennlinie des Inverters steuern. Zudem können optional Kaskodetransistoren MP6 und MN6 eingefügt sein, die über die Steuersignale VPP bzw. VNN gesteuert werden und zur Erweiterung des Frequenzbereichs dienen. Insgesamt ist aus Fig. 4 ersichtlich, daß die Inverterschaltung aus im wesentlichen spiegelsymmetrischenp-Kanal-undn-Kanal-MOS-Transistorbereichen besteht.

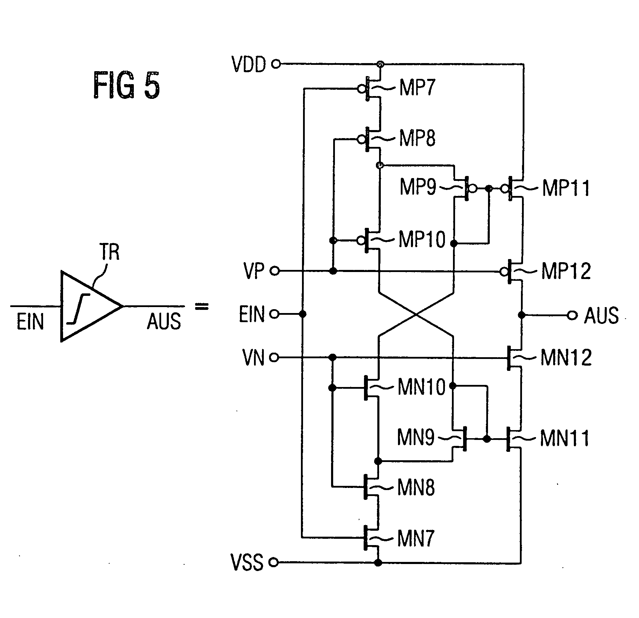

Wie bereits anhand Fig. 3 erläutert worden ist, können auch die einzelnen Treiber TR1 - TR4 abhängig von dem Ausgangssignal des Regelverstärkers RV eingestellt werden, wobei es für eine minimale Störabstrahlung insbesondere zweckmäßig ist, die Flankensteilheiten dieser Ausgangstreiber proportional zur Oszillatorfrequenz der Ladungspumpe einzustellen. Fig. 5 zeigt ein Beispiel einer querstromfreien Treiberschaltung mit den genannten Merkmalen, wobei die Flankensteilheit insbesondere abhängig von den Steuersignalen VN, VP (vergl. Fig. 4) einstellbar ist. Auch die in Fig. 5 gezeigte Treiberschaltung umfaßt wiederum die Kombination von p-Kanal- und n-Kanal-MOS-Sperrschichttransistoren MP7 - MP12 bzw. MN7 - MN12, wobei der Bereich mit den p-Kanal-Transistoren im wesentlichen spiegelsymmetrisch zu dem Bereich mit den n-Kanal-Transistoren aufgebaut ist.

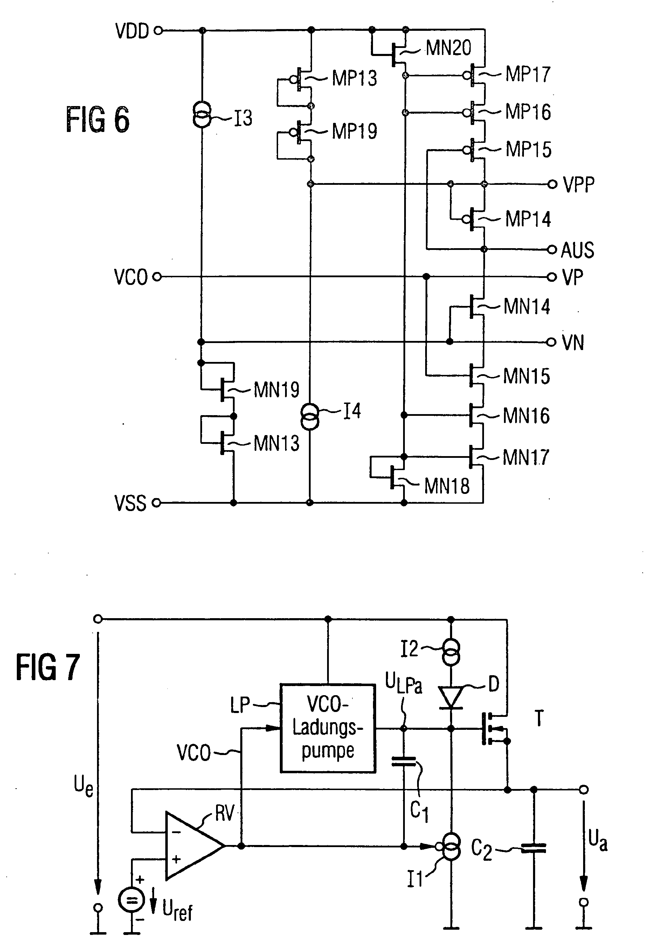

Der in Fig. 4 gezeigte Integrator sowie der in Fig. 5 gezeigte Treiber werden abhängig von Steuersignalen VP, VPP, VNN und VN angesteuert, welche aus dem Ausgangssignal VCO des Regelverstärkers RV (vergl. Fig. 1) abgeleitet werden. Demzufolge muß die in Fig. 3 gezeigte Ladungspumpe eine Steuerschaltung aufweisen, welche abhängig von dem Ausgangssignal VCO des Regelverstärkers RV die entsprechenden Steuersignale VP, VPP, VNN bzw. VN erzeugt. Eine entsprechende Steuerschaltung ist beispielhaft in Fig. 6 dargestellt, die wiederum eine Kombination von p-Kanal-Sperrschicht-Feldeffekttransistoren MP13 - MP1 und n-Kanal-Sperrschicht-Feldeffekttransistoren MN13 - MN20 aufweist. Des weiteren umfaßt die Steuerschal

tung interne Stromquellen I3 und I4. Die nähere Verschaltung kann Fig. 6 entnommen werden.

Da gemäß Fig. 3 die einzelnen Integratoren IN1 - IN4 und Treiber TR1 - TR4 gemeinsam abhängig von dem Steuersignal VCO des Regelverstärkers RV eingestellt werden sollen, genügt es, eine der in Fig. 6 gezeigten Schaltung entsprechende zentrale Steuerschaltung in der Ladungspumpe vorzusehen, die abhängig von dem Steuersignal VCO die Steuersignale VPP, VP, VN und VNN erzeugt. Alternativ ist jedoch auch denkbar, daß die in Fig. 6 gezeigte Schaltung in jede der in Fig. 4 und 5 gezeigten Schaltungen, d. h. in jede Integrator- und Treiberschaltung, integriert wird.

Fig. 7 zeigt schließlich ein weiteres bevorzugtes Ausführungsbeispiel des erfindungsgemäßen Spannungsreglers, wobei insbesondere die in Fig. 3 gezeigte frequenzvariable Ladungspumpe LP (VCO-Ladungspumpe) eingesetzt werden kann, deren Frequenz wiederum abhängig von dem Ausgangssignal VCO des Regelverstärkers RV eingestellt wird, um somit die Frequenz der Ladungspumpe LP an die augenblickliche Last bzw. die erforderliche Stromabgabe anzupassen und somit die Stromaufnahme der Ladungspumpe zu minimieren. Des weiteren ist gemäß Fig. 7 der Regelverstärker RV als sogenannter Class-B-Verstärker mit geringem Ruhestrom ausgeführt und erzeugt bei einer genügend hohen Eingangsspannung (z. B. größer als 8V) ein derartiges Steuersignal VCO für die Ladungspumpe LP, welches der Frequenz 0 entspricht. Um auch in diesem Fall die für den Stelltransistor T erforderliche Gateladung aufrechtzuerhalten, ist gemäß Fig. 7 eine weitere Stromquelle 12 vorgesehen, welche über eine Diode D mit dem Gateanschluß des Transistors T gekoppelt ist. Mit Hilfe der in Fig. 7 gezeigten Spannungsreglerschaltung kann die Stromaufnahme des Spannungsreglers weiter verringert werden.

## Patentansprüche

1. Spannungsreglerschaltung,

   mit einem Eingangsanschluß zum Empfangen einer Eingangsspannung ($U_e$),
   mit einem Ausgangsanschluß zum Bereitstellen einer geregelten Ausgangsspannung ($U_a$),
   mit einem Transistor (T), dessen Hauptstrompfad zwischen den Eingangsanschluß und den Ausgangsanschluß geschaltet ist,
   mit einem Regelverstärker (RV), der an einem Eingangsanschluß die geregelte Ausgangsspannung ($U_a$) empfängt und an einem Ausgangsanschluß ein Steuersignal (VCO) bereitstellt,
   mit einem Kondensator (C1), der zwischen den Steueranschluß des Transistor (T) und den Ausgangsanschluß des Regelverstärker (RV) geschaltet ist,

   mit einer steuerbaren Stromquelle (I1) zum Entladen des Kondensators (C1), und
   mit einer Ladungspumpe (LP), die eine durch den Regelverstärker (RV) steuerbare Spannung an den Steueranschluß des Transistors (T) anlegt,

   **dadurch gekennzeichnet ,**
   **daß** die Schaltfrequenz der Ladungspumpe (LP) abhängig von dem Steuersignal (VCO) des Regelverstärkers (RV) veränderbar ist.

2. Spannungsreglerschaltung nach Anspruch 1,
   **dadurch gekennzeichnet ,**
   **daß** der Transistor (T) ein DMOS-Feldeffekttransistor ist.

3. Spannungsreglerschaltung nach einem der Ansprüche 1 oder 2,
   **dadurch gekennzeichnet ,**
   **daß** der Regelverstärker (RV) ein Class-B-Verstärker mit geringem Ruhestrom ist.

4. Spannungsreglerschaltung nach Anspruch 3,
   **dadurch gekennzeichnet ,**
   **daß** eine weitere Stromquelle (12) mit dem Steueranschluß des Transistors (T) gekoppelt ist,
   **daß** der Regelverstärker (RV) bei einer Eingangsspannung bestimmter Größe ein der Schaltfrequenz Null entsprechendes Steuersignal (VCO) für die Ladungspumpe (LP) erzeugt, und
   **daß** die weitere Stromquelle (12) derart ausgestaltet und angeordnet ist, daß sie auch bei dem der Schaltfrequenz Null entsprechenden Steuersignal (VCO) des Regelverstärkers (RV) eine ausreichend hohe Steuerladung für den Steueranschluß des Transistors (T) aufrechterhält.

FIG 1

FIG 2A

FIG 2B

FIG 2C

FIG 3

# FIG 4

EP 1 528 662 A1

FIG 5

FIG 6

FIG 7

# FIG 8
(Stand der Technik)

$U_e$

$U_a$

RV

$U_{ref}$

I

C

# FIG 9
(Stand der Technik)

LP

Ladungspumpe

I2

T

RV

$U_e$

$U_a$

$U_{ref}$

I1

C

# FIG 10
(Stand der Technik)

# EP 1 528 662 A1

**Europäisches Patentamt**

## EUROPÄISCHER RECHERCHENBERICHT

Nummer der Anmeldung

EP 05 00 1856

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y,D | US 5 654 628 A (FELDTKELLER MARTIN) 5. August 1997 (1997-08-05) | 1 | H02M3/07 |
| A | * das ganze Dokument *<br>----- | 2-4 | |
| Y | WAI LAU ET AL: "An integrated controller for a high frequency buck converter" POWER ELECTRONICS SPECIALISTS CONFERENCE, 1997. PESC '97 RECORD., 28TH ANNUAL IEEE ST. LOUIS, MO, USA 22-27 JUNE 1997, NEW YORK, NY, USA,IEEE, US, 22. Juni 1997 (1997-06-22), Seiten 246-254, XP010241555 ISBN: 0-7803-3840-5 | 1 | |
| A | * Zusammenfassung * * Seite 248, linke Spalte, Absatz 3 - Seite 249, rechte Spalte, Absatz 1 * * Seite 252, linke Spalte, Absatz 2 * * Abbildungen 1,3,4,9 *<br>----- | 2-4 | |

| | | | **RECHERCHIERTE SACHGEBIETE (Int.Cl.7)** |
|---|---|---|---|
| | | | H02M |

Der vorliegende Recherchenbericht wurde für alle Patentansprüche erstellt

| Recherchenort | Abschlußdatum der Recherche | Prüfer |
|---|---|---|
| München | 3. März 2005 | Hurtado-Albir, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................................
& : Mitglied der gleichen Patentfamilie, übereinstimmendes Dokument

EPO FORM 1503 03.82 (P04C03)

15

**EP 1 528 662 A1**

**ANHANG ZUM EUROPÄISCHEN RECHERCHENBERICHT**
**ÜBER DIE EUROPÄISCHE PATENTANMELDUNG NR.**

EP 05 00 1856

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-03-2005

| Im Recherchenbericht angeführtes Patentdokument | Datum der Veröffentlichung | Mitglied(er) der Patentfamilie | Datum der Veröffentlichung |
|---|---|---|---|
| US 5654628 A | 05-08-1997 | DE 4442466 C1<br>DE 59507999 D1<br>EP 0715237 A2 | 14-12-1995<br>20-04-2000<br>05-06-1996 |

Für nähere Einzelheiten zu diesem Anhang : siehe Amtsblatt des Europäischen Patentamts, Nr.12/82

EPO FORM P0461